# EUROPÄISCHE PATENTANMELDUNG

(11) **EP 0 687 062 A1**
(43) Veröffentlichungstag der Anmeldung: **13.12.1995**
(21) Anmeldenummer: 95108756.8
(22) Anmeldetag: 07.06.1995
(51) Int. Cl.: H03H 7/20, H01P 1/185

(54) **Analoger Phasenschieber für kleine Steuerspannungen**

(30) Priorität: 09.06.1994 DE 4420197
(71) Anmelder: SIEMENS AKTIENGESELLSCHAFT, D-80333 München (DE)
(72) Erfinder: Sedlmair, Siegfried, Dipl.-Ing., D-86919 Utting (DE); Matzke, Claus, D-85521 Ottobrunn (DE); Wildmoser, Johann, Dipl.-Ing., D-85276 Pfaffenhofen (DE)

(57) **Zusammenfassung**

Oszillatoren in Phasenregelschleifen zur Taktrückgewinnung enthalten in der Regel Varaktordioden, die Steuerspannungen von ca. 10 Volt benötigen. Für den Ersatz von Varaktordioden wurde ein Analogphasenschieber entwickelt, der nach dem Prinzip des Vektorphasenschiebers mit drei Signalwegen arbeitet, wobei nur in zwei Signalwegen steuerbare aktive Elemente in Form von PIN-Dioden oder Feldeffekttransistoren enthalten sind und nur noch Steuerspannungen unter 1 Volt benötigt werden.

## Beschreibung

Die Erfindung betrifft einen analogen Phasenschieber entsprechend dem Oberbegriff des Anspruchs 1.

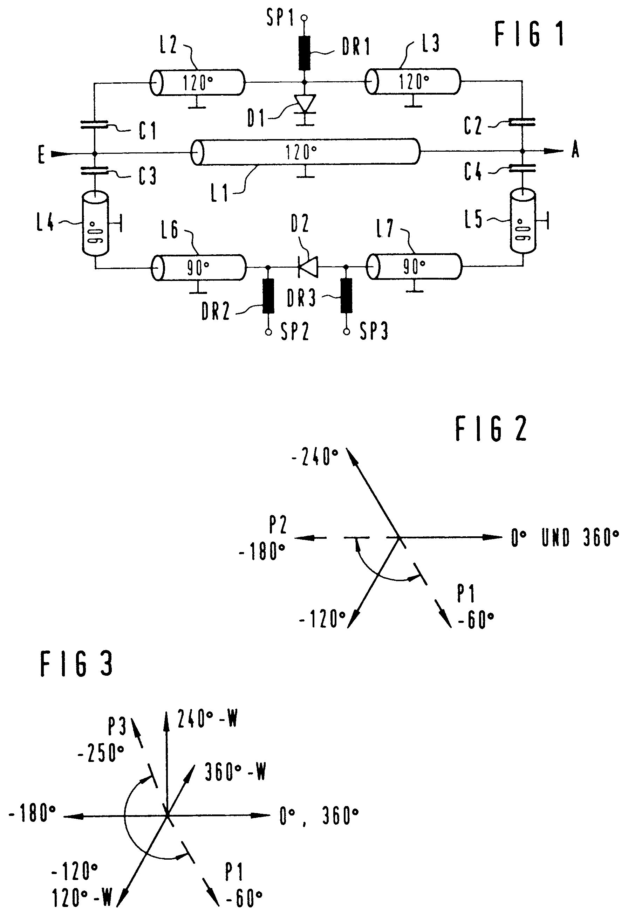

Aus 1984 IEEE "Microwave Theory and Technique Symposium Digest" Seiten 384 bis 386 ist ein analoger Phasenschieber der vorgenannten Art bekannt. Entsprechend Figur 1 auf Seite 385 und zugehöriger Beschreibung sind zwischen einem eingangsseitigen Teiler und einem ausgangsseitigen Kombinator drei parallele Signalwege vorgesehen, die jeweils einen steuerbaren und damit aktiven Widerstand zur Veränderung der Signalamplitude enthalten. Zusätzlich enthalt der zweite und der dritte Weg passive Elemente zur Phasenverschiebung, wobei der zweite Weg auf 120° Phasenverschiebung für die durchlaufenden Signale und der dritte Weg auf 240° Phasenverschiebung eingestellt ist, so daß die einzelnen Signalwege zueinander jeweils 120° Phasenverschiebung aufweisen. Mit dieser Anordnung ist durch die vektorielle Addition der Ausgangssignale der drei Signalwege eine kontinuierliche Veränderung der Phasenverschiebung über insgesamt 360° möglich.

Der bekannte Phasenschieber wird in Verbindung mit einer Radareinrichtung verwendet, derartige Phasenschieber können auch in anderen Bereichen als Phasenmodulatoren oder in Kombination mit einem über den Phasenschieber und einen Resonator als frequenzbestimmendes Netzwerk für die Mittenfrequenz zurückgekoppelten Verstärker zur Erzeugung von Schwingungen verwendet werden, deren Phase wie bei Kapazitätsdioden enthaltenden Oszillatoren einem Referenzsignal nachgeführt wird. Der eingangs erwähnte analoge Phasenschieber ist relativ aufwendig aufgebaut, ermöglicht dafür aber eine relativ große Phasenverschiebung. In verschiedenen Anwendungen beispielsweise in Phasenregelschleifen ist eine Phasenverschiebung von 360° nicht erforderlich, dafür ist eine Verringerung des Aufwandes bei einer Eignung für Frequenzen von 10 und mehr GHz erwünscht.

Die Aufgabe der Erfindung besteht also darin, den eingangs erwähnten analogen Phasenschieber so weiter zu entwickeln, daß der Aufwand erheblich verringert wird, außerdem sollte eine Ausführung als integrierte Mikrowellenschaltung möglich sein.

Erfindungsgemäß wird die Aufgabe dadurch gelöst, daß der eingangs erwähnte Phasenschieber entsprechend den im Kennzeichen des Patentanspruches 1 erhaltenen Merkmalen weitergebildet ist.

Die erfindungsgemäße Lösung bietet den Vorteil, daß nur zwei aktive Elemente angesteuert werden und dadurch auch der Aufwand in der Ansteuerschaltung sinkt, gegenüber einem mittels Kapazitätsdioden realisierten Phasenschieber ergibt sich der für Phasenregelschleifen besondere Vorteil, daß um eine Zehnerpotenz niedrigere Ansteuerspannungen von etwa 1 Volt benötigt werden, so daß eine Integration in vorhandene Systeme leicht möglich ist. Eine weitere Verringerung des Aufwandes gegenüber dem Stand der Technik ergibt sich durch den Verzicht auf Eingangs- und Ausgangskoppler. Eine spezielle Ausbildung des erfindungsgemäßen Phasenschiebers mit konzentrierten Schaltelementen ermöglicht eine weitere Miniaturisierung, die die Einfügung in bestehende Einrichtungen erleichtert.

Die Erfindung soll im folgenden anhand von in der Zeichnung dargestellten Ausführungsbeispielen näher erläutert werden.

In der Zeichnung zeigt:
- Fig. 1: ein erstes Ausführungsbeispiel des erfindungsgemäßen Phasenschiebers mit PIN-Dioden,
- Fig. 2: eine Darstellung der theoretisch zu erwartenden Phasenschiebung im Phasenverschieber nach Figur 1.
- Fig. 3: die im Phasenschieber nach Figur 1 unter dem Einfluß der Diodenkapazitäten auftretende Phasenverschiebung,
- Fig. 4: die Veränderung der Diodendurchlaßströme in Abhängigkeit von der Ansteuerspannung in der Anordnung nach Figur 1,
- Fig. 5: ein zweites Ausführungsbeispiel des erfindungsgemäßen Phasenschiebers mit Feldeffekttransistoren und
- Fig. 6: ein weiteres Ausführungsbeispiel des erfindungsgemäßen Phasenschiebers mit konzentrierten Bauelementen.

Der in der Figur 1 dargestellte Phasenschieber enthält einen ersten, zweiten und dritten Signalweg, die den Eingang E des Phasenschiebers mit dessen Ausgang A verbinden. Am Eingang liegt ein Sinussignal mit einer Frequenz von 10 GHz an, Eingang und Ausgang sind mit 50 Ω abgeschlossen.

Der erste Signalweg besteht aus einem ersten passiven Element L1 in Form eines Leitungsstückes, dessen Länge so bemessen ist, daß sich für das anliegende Signal eine Phasenverschiebung von 120° bei einem Wellenwiderstand von 90 Ω ergibt.

Der über einen ersten Kondensator C1 mit dem Eingang E und über einen zweiten Kondensator C2 jeweils als Trennkondensator mit dem Ausgang A verbundene zweite Signalweg enthalt die Reihenschaltung eines zweiten und dritten passiven Elementes L2, L3 in Form jeweils eines Leitungsstuckes mit einem Wellenwiderstand von 70 Ω und einer Phasenverschiebung von je 120° für die durchlaufenden Signale. Der Verbindungspunkt des zweiten und dritten passiven Elementes L2, L3 ist einerseits über eine erste Drossel DR1 mit einem ersten Steuerspannungsanschluß SP1 und andererseits über eine erste PIN-Diode D1 als steuerbarem Widerstand mit Bezugspotential verbunden.

Der dritte Signalweg ist über einen dritten Kondensator C3 mit dem Eingang E und über einen vierten Kondensator C4 jeweils als Trennkondensatoren mit dem Ausgang A verbunden. Mit dem dritten Kondensator C3 ist als viertes passives Element L4 ein Wellenleiterstuck mit einem Wellenwiderstand von 70 Ω und einer Phasenverschiebung von 90° verbunden, entsprechend ist an den vierten Kondensator C4 als fünftes passives Element L5 ein weiteres Wellenleiterstück mit einem Wellenwiderstand von ebenfalls 70 Ω und einer Phasenverschiebung von ebenfalls 90° verbunden. Das vierte passive Element L4 ist über ein weiteres Wellenleiterstück mit einem Wellenwiderstand von 50 Ω bei einer Phasenverschiebung von 90° als sechstes passives Element L6 mit dem einen Anschluß einer zweiten PIN-Diode D2 als zweitem steuerbaren Widerstand und über eine zweite Drossel DR2 mit einem zweiten Steuerspannungsanschluß SP2 verbunden. Im Hinblick auf den symmetrischen Aufbau schließt sich an das fünfte passive Element L5 das siebente passive Element L7 an, das wie das sechste passive Element L6 eine Phasenverschiebung von 90° und einen Wellenwiderstand von 50 Ω aufweist und mit dem zweiten Anschluß der zweiten PIN-Diode D2 sowie über eine dritte Drossel DR3 mit dem dritten Steuerspannungsanschluß SP3 verbunden ist. Der symmetrische Aufbau des dritten Signalweges mit vier Leitungsstücken, von denen jeweils zwei gleichen Wellenwiderstand aufweisen, wurde im Hinblick auf die Transformation des Durchlaß- bzw. Sperrwiderstandes der zweiten PIN-Diode D2 auf den Eingang E bzw. auf den Ausgang A gewählt. Bei Hochohmigkeit der PIN-Diode D2 wird der Leerlauf durch die 180° Phasendrehung des vierten und sechsten bzw. fünften und siebenten passiven Elementes auf den Eingang und den Ausgang transformiert und stört dadurch nicht. Entsprechend wirkt sich die Niederohmigkeit der ersten PIN-Diode D1 nicht als Kurzschluß des Einganges E bzw. des Ausganges A aus. Bei einer gegenüber Figur 1 vereinfachten Version wurden viertes und sechstes passives Element sowie fünftes und siebentes passives Element zu jeweils einem passiven Element mit einheitlichem Wellenwiderstand zusammengefaßt.

Die Wellenwiderstände der drei Leitungswege sind, da diese mehr oder weniger parallel geschaltet sind, höher als die Anschlußwerte gewählt. Dadurch wurde erreicht, daß bei möglichst linearer Phasenänderung die Amplitudenschwankungen und Reflexionen unter einem Minimalwert liegen. Besondere Vorteile ergeben sich dabei dadurch, daß die zweite PIN-Diode D2 zwischen niederohmige Anschlüsse geschaltet ist, was durch das als transformierende Lambda-Viertelleitungen ausgebildete sechste und siebente passive Element L6, L7 erreicht wird. Die drei Leitungswege können eine zusätzliche positive oder negative Phasenverschiebung aufweisen, die aber für alle Leitungswege gleich sein muß, damit die gegenseitige Phasenverschiebung von 120° erhalten bleibt.
Bei einer praktischen Realisierung der vorstehend beschriebenen Schaltung in Microstriptechnik für Frequenzen im Bereich von 10 GHz waren den Steuerspannungsanschlüssen Lambda-Viertel-Sperren für die Arbeitsfrequenz vorgeschaltet. Außerdem wurden wegen des einfacheren Aufbaus der dritte Kondensator C3 in die Verbindung zwischen vierten und sechsten passiven Element L4, L6 und der vierte Kondensator in die Verbindung zwischen fünftem und siebentem passiven Element L5, L7 eingeschaltet.

In der Figur 2 ist die Phasenverschiebung eines Signals beim Durchgang durch den Phasenschieber nach Figur 1 ohne Berücksichtigung der Kapazität der PIN-Dioden dargestellt. Es sind zunächst die Phasenverschiebungen von -120° für den ersten Signalweg, -240° für den zweiten Signalweg und 0 bzw. -360° für den dritten Signalweg gezeigt. Durch Verändern des Durchlaßstroms der PIN-Dioden D1, D2 lassen sich nun Hochfrequenz-Widerstandswerte von einigen Ohm bis zu einigen Kiloohm einstellen, wobei im Falle der Niederohmigkeit der beiden PIN-Dioden D1, D2 der zweite Signalweg praktisch gesperrt und der dritte durchlässig ist. Die resultierende Phase ergibt sich durch Addition des Vektors von - 120° des ersten und 0 bzw. - 360° des dritten Signalweges zu P1 gleich -60°. Im Falle der Hochohmigkeit der beiden PIN-Dioden D1 und D2 ist der zweite Signalweg durchlässig und der dritte Signalweg gesperrt, so daß sich durch vektorielle Addition ein zweiter Vektor P2 von -180° Phasenverschiebung ergibt.

In der Figur 3 ist die Phasenverschiebung eines Signals beim Durchgang durch den Phasenschieber nach der Figur 1 bei einer Frequenz von ebenfalls 10 GHz und einer Diodenkapazität von 0,1 pF dargestellt. Wahrend sich der 120°- Weg (120°-W) nicht verändert, wird der zweite Signalweg (240°-W) mit einer Phasenverschiebung von -240° auf ca. -270° verlängert, außerdem wird der dritte Signalweg (-360°-W)verändert. Bei Diodenwiderständen von etwa 5 Ohm - 2,5 Kiloohm ergibt sich damit ein erreichbarer Phasenhub von etwa 190° anstelle von ursprünglich 120°, durch die Diodenkapazität wird also der Arbeitsbereich des erfindungsgemäßen Analogphasenschiebers vergrößert.

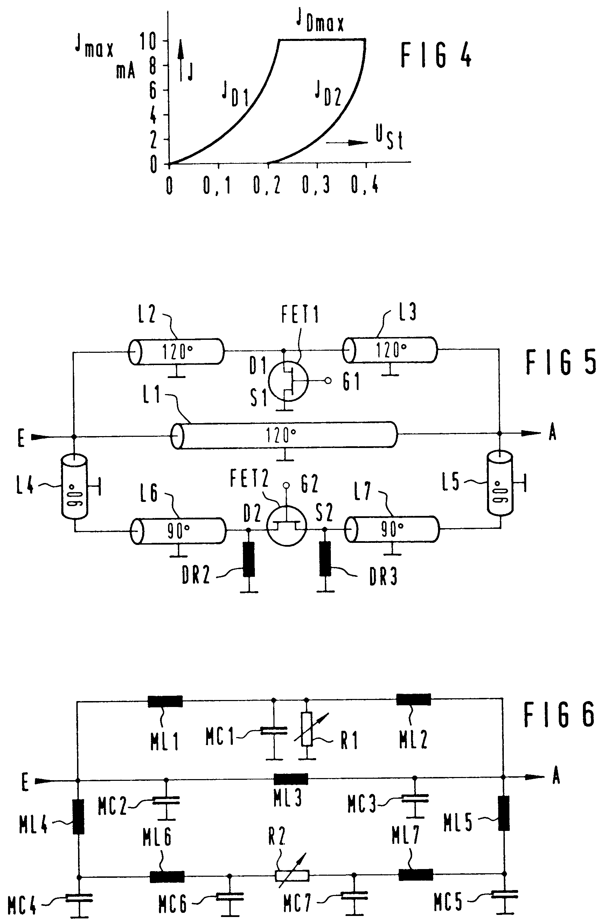

In der Figur 4 ist der Verlauf der Durchlaßströme I_{D1}, I_{D2} durch die PIN-Dioden D1, D2 dargestellt. Der in der Figur 4 dargestellte Stromverlauf ergibt eine angenähert lineare Phasenänderung in Abhängigkeit von der Steuerspannung, wobei im Hinblick auf die gleichmäßige Phasensteuerung über den gesamten Einstellbereich diese besondere Stromaufteilung auf die beiden PIN-Dioden D1, D2 gewählt wurde. Die Durchlaßströme müssen nämlich schneller als linear ansteigen, für den vorliegenden Fall wurde ein exponentieller Verlauf gewählt. Außerdem steigen beim Ausführungsbeispiel die Durchlaßströme für die beiden Dioden gleichartig an, da dies die Ansteuerung vereinfacht und durch die zusätzliche Transformation der Diodenwiderstände über die Leitungswellenwiderstände weitere Möglichkeiten der Anpassung bestehen.

Ausgehend vom hochohmigen Zustand der beiden PIN-Dioden D1, D2 im spannungslosen Zustand steigt mit steigender Steuerspannung U_{St} zunächst der Durchlaßstrom I_{D1} der ersten PIN-Diode D1 bis zu seinem Maximalwert I_{D1max} an, während die zweite PIN-Diode D2 gesperrt bleibt. Etwa beim Erreichen des maximalen Durchlaßstroms I_{D1max} der ersten PIN-Diode D1 beginnt die zweite PIN-Diode D2 zu leiten, mit weiter steigender Steuerspannung U_{St} steigt der Durchlaßstrom I_{D2} durch die zweite PIN-Diode D2 bis zu einem Maximalwert an, der beim Ausführungsbeispiel dem der ersten PIN-Diode D1 entspricht. Mit dem Anstieg des Durchlaßstroms durch die erste PIN-Diode D1 schwenkt die resultierende Phase von etwa -250° auf ca. -120°, da bei maximalem Durchlaßstrom I_{D1max} durch die erste PIN-Diode D1 und Sperrung der zweiten PIN-Diode D2 der zweite und der dritte Signalweg gesperrt sind. Anschließend beginnt die zweite PIN-Diode D2 zu leiten, so daß die resultierende Phase weiter bis auf -60° dreht und sich insgesamt ein Phasenhub von 190° ergibt. Wie aus Figur 4 erkennbar, genügen zur Ansteuerung der PIN-Dioden Steuerspannungen deutlich unter 1 Volt, so daß sich eine relativ einfache und leicht zu integrierende Ansteuerschaltung ergibt.

Der in Figur 5 dargestellte erfindungsgemäße Analog-Phasenschieber entspricht in seinem Aufbau dem der Figur 1, allerdings sind die erste und zweite PIN-Diode D1, D2 durch einen ersten und zweiten GaAs-Feldeffekttransistor FET1, FET2 ersetzt. Mit dem Verbindungspunkt der das zweite bzw. dritte passive Element L2, L3 darstellenden Leitungsstücke ist nunmehr der Drain-Anschluß D1 des ersten Feldeffekttransistor FET1 verbunden, während die erste Drossel DR1 entfällt. Der Gate-Anschluß G1 des ersten Feldeffekttransistors ist mit dem ersten Steuerspannungsanschluß SP1 verbunden, der Source-Anschluß S1 des ersten Feldeffekttransistors FET1 ist mit Bezugspotential verbunden.

Mit dem sechsten passiven Element L6 ist der Drain-Anschluß D2 des zweiten Feldeffekttransistors FET2 und weiterhin die zweite Drossel DR2 verbunden, deren anderer Anschluß nunmehr auf Bezugspotential liegt. Mit dem entsprechenden Anschluß des siebenten passiven Elementes L7 ist nunmehr der Source-Anschluß S2 des zweiten Feldeffekttransistors FET2 und weiterhin die dritte Drossel DR3 verbunden, deren anderer Anschluß ebenfalls auf Bezugspotential liegt. Der Gate-Anschluß G2 des zweiten Feldeffekttransistors FET2 ist mit einem zweiten Steuerspannungs-Anschluß verbunden, wobei durch die Verwendung der GaAs-Feldeffekttransistoren neben der besonders guten Hochfrequenzeignung der Vorteil kleiner Steuerspannungen und einer leistungslosen Steuerung auftritt. Die Drain-Source-Strecken der Feldeffekttransistoren bilden dabei die steuerbaren Widerstände, wobei mittels der Gate-Source-Spannung der Widerstand der Drain-Source-Strecken eingestellt wird. Im Hinblick auf die Preisgünstigkeit der PIN-Dioden ist auch eine Kombination aus den Figuren 1 und 5 möglich, bei der nur eine der beiden PIN-Dioden durch einen GaAs-Feldeffekttransistor ersetzt ist, dabei sind jedoch im Gegensatz zum Wegfall der Trennkondensatoren C1 ... C4 bei der Schaltung nach der Figur 5 für den mit einer PIN-Diode bestückten Signalweg wiederum Trennkondensatoren vorzusehen.

Für Miniaturisierungszwecke kann es vorteilhaft sein, anstelle von Leitungen entsprechend den Figuren 1 und 5 Leitungsersatzschaltungen aus konzentrierten Schaltelementen entsprechend Figur 6 zu verwenden. Die Figur 6 zeigt dabei ein Prinzipschaltbild mit zwei steuerbaren Widerständen R1, R2, die entsprechend den Figuren 1 und 5 durch PIN-Dioden oder Feldeffekttransistoren realisiert werden können. Die Leitungsstücke entsprechend den Figuren 1 und 5 sind mittels Tiefpaß-π-Schaltungen gebildet, wobei einige Kondensatoren zusammengefaßt werden konnten. Der erste Signalweg wird dabei durch ein π-Glied aus einem ersten miniaturisierten Kondensator MC1, einer ersten miniaturisierten Induktivität ML1 und einem zweiten miniaturisierten Kondensator C2 gebildet, der zweite Signalweg ergibt sich durch Zusammenfassung zweier Kondensatoren als T-Glied aus einer zweiten miniaturisierten Induktivität ML2, einem dritten miniaturisierten Kondensator MC3 mit parallelgeschaltetem steuerbaren Widerstand R1 und einer dritten miniaturisierten Induktivität ML3. Per dritte Signalweg enthält ebenfalls ausschließlich miniaturisierte passive Bauelemente. Mit dem Eingang E ist dabei eine vierte Induktivität ML4 verbunden und mit dem Ausgang A eine fünfte Induktivität ML5. Mit dem zweiten Anschluß der vierten Induktivität ML4 ist ein π-Glied aus einem vierten Kondensator MC4, einer sechsten Induktivität ML6 und einem sechsten Kondensator MC6 verbunden, entsprechend ist mit der fünften Induktivität ML5 ein aus einem fünften Kondensator MC5, einer siebenten Induktivität ML7 und einem siebten Kondensator MC7 gebildetes π-Glied verbunden, der zweite steuerbare Widerstand R2 verbindet die sechste und die siebente Induktivität ML6,ML7, die Kondensatoren MC1,...MC7 liegen jeweils mit dem anderen Anschluß auf Bezugspotential.

## Patentansprüche

1. Analoger Phasenschieber vom Durchgangstyp für Frequenzen im Gigahertzbereich mit drei eingangs- und ausgangsseitig parallelgeschalteten, ohne Beeinflussung durch steuerbare Widerstände zueinander jeweils etwa 120° Phasenverschiebung für die durchlaufenden Signale aufweisenden Signalwegen, deren Ausgangssignale vektoriell addiert werden,
**dadurch gekennzeichnet,**
daß der erste Signalweg ein erstes passives Element (L1) mit einer Phasenverschiebung von etwa 120°für die durchlaufenden Signale enthält,
daß der zweite Signalweg die Reihenschaltung eines zweiten und dritten, jeweils Phasenverschiebungen von etwa 120° für die durchlaufenden Signale aufweisenden passiven Elementes (L2, L3) mit zueinander gleichen Wellenwiderständen enthält und zwischen dem Verbindungspunkt beider passiver Elemente (L2, L3) und Bezugspotential ein erster steuerbarer Widerstand (R1, D1, FET1) angeschlossen ist,
daß der Eingang des dritten Signalwegs über eine Reihenschaltung eines vierten und sechsten passiven Elementes (L4, L6) mit einer Phasenverschiebung von jeweils etwa 90° für die durchlaufenden Signale mit dem einen Anschluß eines zweiten steuerbaren Widerstandes (R2, D2, FET2) verbunden ist, dessen anderer Anschluß über eine Reihenschaltung eines fünften und siebenten passiven Elementes (L5, L7) mit einer Phasenverschiebung von jeweils etwa 90° und mit dem Ausgang des dritten Signalweges verbunden ist.

2. Analoger Phasenschieber nach Anspruch 1,
**dadurch gekennzeichnet,**
daß jeweils das vierte und das sechste passive Element (L4, L6) sowie das fünfte und das siebente passive Element (L5, L7) zueinander ungleiche Wellenwiderstände aufweisen und daß die Wellenwiderstände des vierten und fünften sowie des sechsten und siebenten passiven Elementes (L4, L5; L6, L7) jeweils gleich groß sind.

3. Analoger Phasenschieber nach Anspruch 2,
**dadurch gekennzeichnet,**
daß das vierte und das sechste sowie das fünfte und das siebente passive Element (L4, L6; L5, L7) zusammengefaßt sind.

4. Analoger Phasenschieber nach Anspruch 1,
**dadurch gekennzeichnet,**
daß als steuerbare Widerstände PIN-Dioden (D1, D2) vorgesehen sind, die über zusätzliche Drosseln (DR1, DR2, DR3) mit Steuerspannungsanschlüssen verbunden sind und daß zweiter und dritter Signalweg über Trennkondensatoren (C1...C4) mit dem Eingang (E) bzw. dem Ausgang (A) verbunden sind.

5. Analoger Phasenschieber nach Anspruch 4,
**dadurch gekennzeichnet,**
daß die Vorspannung der PIN-Dioden (D1, D2) gleich groß ist und die Vorspannungsänderungen gleichsinnig erfolgen.

6. Analoger Phasenschieber nach Anspruch 1,
**dadurch gekennzeichnet,**
daß als steuerbare Widerstände Feldeffekttransistoren (FET1, FET2) vorgesehen sind und dabei im zweiten Signalweg der Verbindungspunkt des zweiten und dritten passiven Elementes (L2, L3) mit dem Drain-Anschluß (D1) eines ersten Feldeffekttransistors (FET1) verbunden ist, dessen Source-Anschluß (S1) mit Bezugspotential und dessen Gate-Anschluß (G1) mit einem ersten Steuerspannungsanschluß verbunden ist,
daß die Reihenschaltung des vierten und sechsten passiven Elements (L4, L6) den Eingang des dritten Signalweges mit dem Drain-Anschluß (D2) eines zweiten Feldeffekttransistors (FET2) verbindet, daß dessen Gate-Anschluß (G2) mit einem zweiten Steuerspannungsanschluß und der Source-Anschluß (S2) des zweiten Feldeffekttansistors (FET2)über die Reihenschaltung des siebenten und des fünften passiven Elements (L7, L5) mit dem Ausgang des dritten Signalweges verbunden ist und daß die Source- und Drain-Anschlüsse des zweiten Feldeffekttransistors (FET2) über eine vierte bzw. fünfte Drossel (DR4, DR5) mit Bezugspotential verbunden sind.

7. Analoger Phasenschieber nach den Ansprüchen 1 bis 6,
**dadurch gekennzeichnet,**
daß als passive Elemente (L1, ..., L7) Leitungsstücke geeigneter Länge vorgesehen sind.

8. Analoger Phasenschieber nach Anspruch 4,
**dadurch gekennzeichnet,**
daß das erste passive Element (L1) bei einer Phasenverschiebung von 120° einen Wellenwiderstand von 90 Ω aufweist,
daß das zweite und dritte passive Element (L2, L3) bei einer Phasenverschiebung von 120° Wellenwiderstände von 70 Ω aufweisen,
daß das vierte und das fünfte passive Element (L4, L5) bei Phasenverschiebungen von 90° Wellenwiderstände von 70 Ω aufweisen und
daß das sechste und das siebente passive Element (L6, L7) bei Phasenverschiebungen von 90° Wellenwiderstände von 50 Ω aufweisen.

9. Analoger Phasenschieber nach Anspruch 1,
**dadurch gekennzeichnet,**
daß als passive Elemente Leitungsersatzschaltungen aus konzentrierten Bauelementen vorgesehen sind,
daß der erste Signalweg durch ein π-Glied aus einem ersten Kondensator (MC1), einer ersten Induktivität (ML1) und einem zweiten Kondensator (MC2) gebildet ist,
daß der zweite Signalweg die Reihenschaltung einer zweiten und einer dritten Induktivität (ML2, ML3) enthält und am Verbindungspunkt beider Induktivitäten ein dritter Kondensator (MC3) und ein erster steuerbarer Widerstand (R1) nach Masse geschaltet sind,
daß der dritte Signalweg eine vierte Induktivität (ML4)enthält, die einerseits mit dem Eingang (E) des Phasenschiebers und andererseits über einen vierten Kondensator (MC4) mit Bezugspotential verbunden ist, daß der dritte Signalweg weiterhin eine fünfte Induktivität (ML5) enthält, die einerseits mit dem Ausgangsanschluß (A) des Phasenschiebers und andererseits über einen fünften Kondensator (MC5) mit Bezugspotential verbunden ist,
daß am Verbindungspunkt der vierten Induktivität (ML4) und des vierten Kondensators (MC4) eine sechste Induktivität (ML6) angeschlossen ist, deren anderer Anschluß über einen sechsten Kondensator (MC6) mit Bezugspotential und mit einem Anschluß eines zweiten steuerbaren Widerstandes (R2) verbunden ist,
daß am Verbindungspunkt der fünften Induktivität (ML5) und des fünften Kondensators (MC5) eine siebente Induktivität (ML7) angeschlossen ist, deren anderer Anschluß über einen siebenten Kondensator (MC7) mit Bezugspotential und mit einem zweiten Anschluß des zweiten steuerbaren Widerstandes (R2) verbunden ist.

10. Analoger Phasenschieber nach Anspruch 1 bis 9,
**dadurch gekennzeichnet,**
daß der erste , zweite und dritte Signalweg eine zusätzliche gleiche Phasenverschiebung aufweist.
